# EUROPÄISCHE PATENTANMELDUNG

(11) **EP 2 182 636 A2**
(43) Veröffentlichungstag der Anmeldung: **05.05.2010**
(21) Anmeldenummer: 09174616.4
(22) Anmeldetag: 30.10.2009
(51) Int. Cl.: H03K 17/96

(54) **Bedienvorrichtung für ein Hausgerät**

(30) Priorität: 31.10.2008 DE 102008043351
(71) Anmelder: BSH Bosch und Siemens Hausgeräte GmbH, 81739 München (DE)
(72) Erfinder: Gotschy, Robert, 83607 Holzkirchen (DE); Pietruska, Ralph, 81541 München (DE)

(57) **Zusammenfassung**

Die Bedienvorrichtung (1) für ein Hausgerät weist eine Platte (2) auf, deren Vorderseite als Bedienoberfläche (3) vorgesehen ist und an deren Rückseite (4) mindestens ein druckempfindlicher, insbesondere resistiver, Sensor (6) angeordnet ist, wobei die Vorderseite (3) mindestens ein dreidimensional strukturiertes Bedienerführungselement (8) aufweist.

## Beschreibung

Die Erfindung betrifft eine Bedienvorrichtung für ein Hausgerät mit einer Platte, deren Vorderseite als Bedienoberfläche vorgesehen ist und an deren Rückseite mindestens ein Sensor angeordnet ist, und ein Hausgerät mit mindestens einer solchen Bedienvorrichtung.

WO 2005/019766 A2 offenbart einen Positionssensor, der einen Drehknopf und ein resistives Sensorelement aufweist. Der Drehknopf wird mittels eines Magneten an einem Bedienpaneel gehalten und weist an seinem Umfang ein leitfähiges, räumlich begrenztes Volumen auf. Am Ort des leitfähigen Volumens wird eine kapazitive Kopplung mit dem resistiven Sensorelement bewirkt, welche vom resistiven Sensorelement ortsaufgelöst detektiert wird.

DE 10 2004 013 947 B3 offenbart eine Bedienvorrichtung für ein Glaskeramikkochfeld in der Form eines Drehknopfs, bei welcher an der Unterseite des Drehknopfs ein Messstreifen vorgesehen ist, der auf einer Kreisbahn angeordnet ist und entlang der Kreisbahn kontinuierlich oder stufenweise verändernde physikalische Eigenschaften aufweist; das Glaskeramikkochfeld wenigstens einen Sensor aufweist, der entsprechend der Kreisbahn des Messstreifens angeordnet ist und ein der physikalischen Eigenschaft des dem Sensor gegenüberliegenden Abschnitts des Messstreifens entsprechendes Ausgangssignal erzeugt; und dem wenigstens einen Sensor eine Auswerteeinheit zugeordnet ist, die aus dem Ausgangssignal des Sensors ein der Drehposition des Drehknopfs entsprechendes Stellsignal für das Glaskeramikkochfeld erzeugt. Die Sensoren sind bevorzugt IR- oder kapazitive Sensoren, mit denen der Drehknopf als Touch-Control-Bedienvorrichtung des Glaskeramikkochfeldes eingesetzt werden kann.

DE 19917191 A1 beschreibt ein Bedienelement zum Schalten und Steuern elektrisch bedienbarer Geräte mit einer Blende. wobei ein Träger zur Aufnahme des aufsteckbaren und wieder abziehbaren Bedienelementes auf die durch bruchfreie Frontblende aufgeklebt wird. Im Bedienelement sind Mittel untergebracht, die eine indirekte Bedienungsübertragung realisieren, wobei die elektrische Sensierung der Bedien- bzw. Betätigungsfunktionen durch hinter der Frontblende angebrachte Sensoren erfolgt. Es entfallen somit direkte mechanische Übertragungselemente, die einen Durchbruch durch die Frontblende benötigen

Es ist die Aufgabe der vorliegenden Erfindung, eine besonders einfach herstellbare, flexibel konfigurierbare und bedienerfreundliche Bedienvorrichtung für ein Hausgerät bereitzustellen.

Diese Aufgabe wird mittels einer Bedienvorrichtung und eines Hausgeräts nach den jeweiligen unhängigen Ansprüchen gelöst. Bevorzugte Ausführungsformen sind insbesondere den abhängigen Ansprüchen entnehmbar.

Die Bedienvorrichtung für ein Hausgerät weist eine Platte auf, deren Vorderseite als Bedienoberfläche vorgesehen ist und an deren Rückseite ein berührungsempfindlicher, insbesondere resistiver, Sensor angeordnet, insbesondere fest verbunden aufgebracht, ist, wobei die Vorderseite mindestens ein dreidimensional strukturiertes Bedienerführungselement aufweist. Als Platte wird hier allgemein ein dünner Gegenstand aus einem festem Material bezeichnet. Durch eine Annäherung an die Bedienoberfläche oder eine Berührung der Bedienoberfläche, z. B. mittels eines Fingers eines Bedieners, eines Stifts oder eines anderen Objekts, wird ein dahinterliegender Flächenabschnitt lokal aktiviert ("Cursorfokus"), was ortsaufgelöst erfassbar ist. Der Cursorfokus umfasst die Menge der aktivierten Sensorpunkte.

Typischerweise weist der Sensor ein oder mehrere Schaltzonen mit jeweils ein oder mehreren Sensorpunkten auf, bei deren Aktivierung eine vorbestimmte Schaltfunktion des Hausgeräts ausgelöst wird. Unter einer Schaltfunktion wird eine allgemeine Gerätefunktion verstanden, die durch eine Aktivierung einer zugeordneten Schaltzone ausgelöst wird, wie eine Einstellung eines Betriebsartenparameters (Kochstufe, Backofentemperatur, Waschgang, Geschirrspülart, Wattzahl, Gefriertemperatur usw.), einen Start einer Betriebsart, eine Anhalten einer Betriebsart, einer Menusteuerung usw. Eine Aktivierung einer Schaltfunktion entspricht in ihrer Auswirkung insbesondere einer Betätigung eines herkömmlichen Bedienelements, wie eines Drehwählers, Schalters, Tasters, Sliders, und so weiter. Mittels einer Steuereinheit wird überprüft, ob ein Cursorfokus zumindest teilweise mit einer vorbestimmten Schaltzone des Sensors übereinstimmt, also z. B. ein oder mehrere Sensorpunkte der Schaltzone im Cursorfokus liegen. Falls dies der Fall ist, wird die entsprechende Schaltfunktion ausgelöst. Die Steuereinheit kann beispielsweise ein Controller sein.

Mittels des dreidimensional strukturierten Bedienerführungselements wird einem Bediener eine verbesserte haptische Rückmeldung gegeben. Insbesondere kann ein Finger sicher geführt werden, was ein Verrutschen unwahrscheinlich macht. Dadurch wiederum kann eine Schaltfunktion sicherer aktiviert werden.

Der Sensor ist vorzugsweise ein resistiver und / oder kapazitiver Sensor, dessen Wirkungsweise gut bekannt ist.

Vorzugsweise ist einem Bedienerführungselement eine vorbestimmte Schaltzone zugeordnet. Jedoch ist eine Schaltzone nicht auf das Vorhandensein eines Bedienerführungselements eingeschränkt, sondern kann beispielsweise auch einer Fläche der Bedienoberfläche hinterlegt sein, welche kein Bedienerführungselement aufweist.

Es ist eine Ausgestaltung, dass der Sensor ein Flächensensor ist, d.h. insbesondere, dass die zugehörige Sensorfläche, welche durch die Gesamtheit der möglichen Sensorpunkte und Schaltzonen gebildet wird, nicht auf eine im Wesentlichen eindimensionale Form (Linie, Kreis o.ä.) beschränkt zu sein braucht. Der Flächensensor kann jedoch auch so eingestellt sein, dass seine Schaltzonen ein bestimmtes, auch im Wesentlichen eindimensionales oder punktförmiges geometrisches Muster aufweisen, z.B. ein kompaktes Schachbrettmuster, ein Matrixmuster beabstandeter Einzelschaltzonen, ein ringförmiges Muster mit verschiedenen sektorartigen Schaltzonen, ein Linienmuster mit verschiedenen geradlinigen Schaltzonen und so weiter.

Es ist eine weitere Ausgestaltung, dass der Sensor ein Liniensensor ist, d.h. insbesondere, dass eine Anordnung seiner Schaltzonen eine eindimensionale Form (gerade und/oder gekrümmte Linie, Kreis o.ä.) beschreibt. Dabei ergibt sich eine Ausdehnung in die zweite Dimension (z.B. eine Breite der Linie oder des Kreises) über die Breite der Schaltzonen.

Es ist noch eine weitere Ausgestaltung, dass der Sensor eine Gruppe von Einzelsensoren mit jeweils einer Schaltzone umfasst.

Der Sensor kann auch eine Kombination dieser Sensorarten sein.

Allgemein kann der Sensor je Schaltzone ein oder mehrere Sensorpunkt aufweisen.

Es kann eine Bedienvorrichtung bevorzugt sein, bei der das Bedienerführungselement eine Vertiefung aufweist. Durch die Vertiefung und insbesondere deren Rand kann eine haptisch besonders eindeutige Führung erreicht werden.

Es kann auch eine Bedienvorrichtung bevorzugt sein, bei der das Bedienerführungselement eine Erhebung aufweist. Diese ist optisch besonders gut erkennbar und haptisch ebenfalls gut spürbar.

Vorzugsweise ist ein, vertieftes und / oder erhabenes, Bedienerführungselement vorzugsweise kreisförmig ausgestaltet, einschließlich oval. Solche tasterartigen Betätigungen sind insbesondere für Schaltfunktionen geeignet, die bei herkömmlichen Hausgeräten von Tastern aktiviert werden. Dadurch kann einem Bediener ein vertrauter Bedienvorgang bereitgestellt werden.

Insbesondere zur Unterstützung von linearen Gleitbetätigungen ist ein, vertieftes und / oder erhabenes, Bedienerführungselement vorzugsweise länglich ausgestaltet. Solche Gleitbetätigungen sind insbesondere für Schaltfunktionen geeignet, die bei herkömmlichen Hausgeräten von Linearslidern oder Schiebereglern aktiviert werden. Sie sind vorzugsweise zur Parameterverstellung vorgesehen.

Insbesondere zur Unterstützung von gekrümmten, insbesondere umlaufenden, Gleitbetätigungen ist ein, vertieftes und / oder erhabenes, Bedienerführungselement vorzugsweise gekrümmt, insbesondere ringförmig, ausgestaltet. Solche Gleitbetätigungen sind insbesondere für Schaltfunktionen geeignet, die bei herkömmlichen Hausgeräten von Zirkularslidern oder Drehknöpfen aktiviert werden. Sie sind vorzugsweise zur Parameterverstellung vorgesehen.

Es wird eine Bedienvorrichtung besonders bevorzugt, bei der die Erhebung ringförmig ist und zumindest zur randseitigen Bedienerführung vorgesehen ist. Eine zugehörige Schaltfunktion, z. B. eine Verstellung eines gerätetypischen Parameterwerts, kann dann mindestens dadurch betätigt werden, dass ein Bediener mit seinem Finger am Außenrand und / oder am Innenrand der ringförmigen Erhebung entlanggleitet und beispielsweise je nach Drehrichtung den Parameter erhöht (z. B. bei Drehung im Uhrzeigersinn) oder erniedrigt (z. B. bei Drehung gegen den Uhrzeigersinn). Die der Schaltfunktion zugeordneten Schaltzonen des Sensors oder mehrere Einzelsensorenbilden dann vorzugsweise mindestens einen mindestens abschnittsweise ringförmigen Bereich, der sich in Aufsicht auf die Betätigungsoberfläche vom Außenrand radial nach Außen erstreckt und/oder sich vom Innenrand radial nach Innen erstreckt, vorzugsweise in Fingerdicke.

Es wird insbesondere eine Bedienvorrichtung bevorzugt, bei der mindestens eines der Bedienerführungselemente zum Aufsetzen eines Bedienelements zur Betätigung des Sensors eingerichtet ist. Dadurch wird eine besonders vielseitig konfigurierbare Bedienvorrichtung geschaffen. Es kann somit ohne hohen Montageaufwand entschieden werden, oder eine Schaltfunktion mittels eines Stifts, Fingers o. ä. betätigbar ist oder mittels einer Betätigung des aufgesetzten Bedienelements. So mag insbesondere das Bedienelement von einem Endkunden individuell aufgesetzt werden, wenn diesem eine Bedienerführung mittels eines Fingers, Stifts o. ä. nicht gefällt. Das Bedienerführungselement kann beispielsweise Rastelemente oder Steckelemente aufweisen, oder für einen Klemm- oder Presseingriff eingerichtet sein.

Es wird dann eine Bedienvorrichtung bevorzugt, welche mindestens ein wahlweise auf ein Bedienerführungselement aufsetzbares und abnehmbares Bedienelement aufweist. Dadurch kann insbesondere ein Bediener wahlweise frei entscheiden, ob er die Schaltfunktionalität mittels eines Stifts, Fingers o. ä. mittels des aufgesetzten Bedienelements betätigen will.

Die Befestigungsart des Bedienelements ist nicht beschränkt und kann beispielsweise eine magnetische Befestigung umfassen. Es wird jedoch bevorzugt, wenn das aufgesetzte Bedienelement mechanisch an der Bedienoberfläche gehalten wird, da so erstens ein sicher Sitz auf die Bedienoberfläche erreicht werden kann und zweitens die Platte und das Bedienelement besonders einfach herstellbar sind, z. B. innerhalb eines Arbeitsgangs, insbesondere ohne Haltemagnete, usw. Zur mechanischen Befestigung werden insbesondere Steckverbindungen und Rastverbindungen bevorzugt.

Es kann bevorzugt sein, wenn das mindestens eine Bedienelement einen Drehknopf aufweist, um so eine Bedienung eines konventionellen Drehknopfs für einen Bediener nachbilden zu können und so eine bekannte Bedienung bereitstellen zu können. Der Drehknopf ist vorzugsweise so ausgestaltet, dass er zum Aufsatz auf eine ringförmige Erhebung eingerichtet ist. Der Drehknopf wirkt somit vorzugsweise mit einem rotationssymmetrischen Bedienerführungselement zusammen. Dazu kann der Drehknopf beispielsweise an seiner Unterseite eine ringförmige oder kreisförmige Aussparung aufweisen. Der Drehknopf weist vorzugsweise außerhalb oder innerhalb des für die Aufnahme der Erhebung vorgesehenen Bereichs einen Vorsprung (z. B. Höcker, Dorn usw.) auf, der lokal eine zur Betätigung des Sensors ausreichende Kontaktierung der Bedienoberfläche hervorruft. Bei einer Drehung des Drehknopfs wandern der Vorsprung und der zugeordnete Cursorfokus auf einer Kreisbahn auf der Bedienoberfläche mit, wobei der Sensor die jeweilige Stellung des Cursorfokus und damit die Drehstellung detektiert.

Es kann aber auch bevorzugt sein, wenn das mindestens eine Bedienelement einen Druckknopf aufweist, um so eine Bedienung eines konventionellen Druckknopfs für einen Bediener nachbilden zu können. Der Druckknopf ist vorzugsweise so ausgestaltet, dass er im Bereich seines Randes an der Bedienoberfläche aufliegt und an einer zentralen Berührfläche unter Druck in Richtung der Bedienoberfläche biegsam ist. Bei ausreichendem Druck oder Annäherung wird ein dahinterliegender Bereich der Bedienoberfläche kontaktiert, so dass der Sensor die Sensorpunkte des entsprechenden dahinterliegenden Cursorfokus' (Punkt oder Fläche) aktiviert. Im unbetätigten Zustand kann der Druckknopf von der Bedienoberfläche beabstandet sein. Der Kontaktbereich des Druckknopfs kann insbesondere an einer Spitze eines auf die Bedienoberfläche zeigenden Vorsprungs (z. B. eines Höckers, Dorns usw.) des Druckknopfs liegen. Der Druckknopf kann beispielsweise auf einer, z. B. ringförmigen oder ringsektorförmigen, Erhebung der Bedienoberfläche oder am Rand einer, z. B. schalenförmigen, Vertiefung aufliegen.

Es kann ferner bevorzugt sein, wenn das mindestens eine Bedienelement ein Schieber ist, um so eine Bedienung eines konventionellen Schiebers für einen Bediener nachbilden zu können. Der Schieber ist vorzugsweise so ausgestaltet, dass er zum Aufsatz auf eine lineare Erhebung oder in eine lineare Vertiefung eingerichtet ist, also mit einem länglichen Bedienerführungselement zusammenwirkt. Auch der Schieber weist vorzugsweise einen Vorsprung (z. B. Höcker, Dorn usw.) auf, der lokal eine zur Betätigung des Sensors ausreichende Kontaktierung der Bedienoberfläche hervorruft. Bei einer Verschiebung des Schiebers wandern die Kontaktfläche und der Cursorfokus mit, wobei der Sensor die jeweilige Stellung detektiert.

Der druckempfindliche Sensor ist vorzugsweise ein resistiver Sensor, da dieser eine nur einfache Ausrüstung benötigt. Besonders bevorzugt wird ein resistiver Sensor mit mindestens einer druckabhängigen Widerstandsschicht aus Indiumzinnoxid (ITO). ITO weist insbesondere den Vorteil auf, dass es in durchsichtigen Schichten hergestellt werden kann. Alternativ können beispielsweise auch FTO ("Fluor Tin Oxide"; Fluorzinnoxid), AZO ("Aluminium Zinc Oxide"; Aluminiumzinkoxid) oder ATO ("Antimony Tin Oxide"; Antimonzinnoxid) verwendet werden.

Die Platte ist vorzugsweise aus Kunststoff, z. B. PMMA oder ABS, oder Glas gefertigt, kann aber auch aus einem Metall bestehen, vorzugsweise mit mehreren voneinander isolierten Teilbereichen. Eine Platte kann mehrere Sensoren und / oder Monitore überdecken.

Zur optischen Kennzeichnung einer Schaltzone kann die Platte, und insbesondere deren Bedienoberfläche, farblich oder schwarz-weiß bemustert sein. Die Bemusterung kann durch ein Aufbringen eines geeigneten Farbstoffs auf die Bedienoberfläche und / oder, bei einer transparenten Platten, auf die Rückseite geschehen. Insbesondere kann die Bemusterung dann durch ein Aufdrucken aufgebracht werden. Die Bemusterung kann aber auch durch ein Einarbeiten von Farbstoff in die Platte eingebracht werden.

Die optische Kennzeichnung einer Schaltzone kann zusätzlich oder alternativ aber auch so geschehen, dass die Platte und der Sensor, insbesondere ITO-Sensor, lichtdurchlässig, insbesondere transparent, sind und der Sensor mittels mindestens eines frei programmierbaren Monitors hintergrundbestrahlt wird. Dadurch ergibt sich insbesondere der Vorteil, dass die optische Kennzeichnung an unterschiedliche Geräteausführungen einfach angepasst werden kann, z. B. durch Einstellung der Farbe (bei einem Farbmonitor) und / oder der Form oder Stärke der optischen Kennzeichnung.

Besonders bevorzugt wird eine Bedienvorrichtung, bei welcher der Sensor, insbesondere Flächensensor, frei programmierbar ist, d. h., dass der Sensor mehrere Sensorpunkte aufweist, wobei eine Zuordnung der Sensorpunkte zu vorbestimmten Schaltzonen und Schaltfunktionen frei einstellbar ist. Dadurch können insbesondere in Ihrer Form und Funktion frei gestaltbare Schaltzonen erzeugt werden. Durch die freie Programmierbarkeit können auf besonders einfache Weise Schaltzonen erzeugt werden, welche an das ihnen vorgelagerte Bedienerführungselement angepasst sind. Insbesondere dabei, aber auch allgemein, kann eine zu einem bestimmten Bedienerführungselement zugehörige Schaltzone dynamisch bezüglich Form, Bedienart und zugehöriger Schaltfunktion umprogrammiert werden, z. B. zur Anpassung an einen bestimmten Schritt innerhalb einer Bedienerführung. Die dynamische Umprogrammierung kann von einer Steuereinheit des Haushaltsgeräts, z. B. einem Mikrocontroller, automatisch vorgenommen werden. Insbesondere umfasst eine Schaltzone die Fläche, welche zur Betätigung von einem Bediener überstrichen werden könnte oder sollte. Auch kann eine einfache gerätespezifische Konfiguration der Bedienvorrichtung, z. B. mit unterschiedlichen Schaltzonen, lediglich durch Austausch der Platte erreicht werden.

Das Hausgerät weist mindestens eine solche Bedienvorrichtung auf.

In den folgenden Figuren wird die Erfindung anhand von Ausführungsbeispielen schematisch genauer beschrieben. Dabei können zur besseren Übersichtlichkeit gleiche oder gleichwirkende Elemente mit gleichen Bezugszeichen versehen sein.
- Fig.1: zeigt in Schrägansicht eine Explosionszeichnung einer Bedienvorrichtung gemäß einer ersten Ausführungsform;
- Fig.2: zeigt die Bedienvorrichtung aus Fig.1 mit einem aufgesetzten Drehknopf;
- Fig.3: in zwei Teilbildern die Bedienvorrichtung aus Fig.1 in Ansicht von vorne (Fig.3A) und von unten (Fig.3B);
- Fig.4: zeigt die Bedienvorrichtung gemäß der ersten Ausführungsform in analoger Darstellung mit einer umprogrammierten Schaltzone;
- Fig.5: zeigt eine Bedienvorrichtung gemäß einer zweiten Ausführungsform;
- Fig.6: zeigt in Vorderansicht die Lage von Komponenten einer Bedienblende mit einer Bedienvorrichtung gemäß einer dritten Ausführungsform.

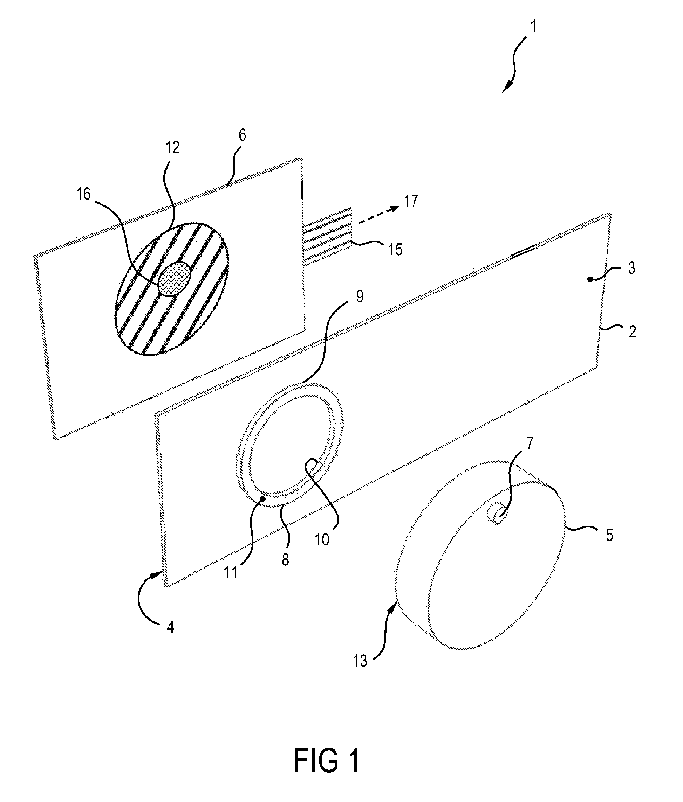

**Fig.1** zeigt in Schrägansicht eine Explosionszeichnung von Komponenten einer Bedienvorrichtung 1, nämlich einer Platte 2 mit einer Bedienoberfläche 3 und einer Rückseite 4, wobei an der Bedienoberfläche 3 ein Drehknopf 5 abnehmbar angebracht ist. Die Bedienvorrichtung 1 weist ferner einen an der Rückseite 4 angeordneten Flächensensor 6 auf.

Die Platte 2 ist von rechteckiger Grundform und einstückig mittels eines Spritzgussverfahrens hergestellt. Während die Rückseite 4 flach ausgebildet ist, weist die Bedienoberfläche 3 ein Bedienerführungselement in Form eines erhabenen, d. h., eines aus der Bedienoberfläche 3 vorstehenden, Rings 8 auf. Ein die Bedienvorrichtung 1 verwendender Bediener kann durch Umstreichen des Rings 8 an dessen Außenfläche 9, Innenfläche 10 oder oberem Rand 11 mittels eines Fingers, Stifts o. ä. eine entsprechende Schaltzone 12 des Flächensensors 6 aktivieren, wie weiter unten genauer beschrieben werden wird. In der gezeigten Figur ist auf den Ring 8 der Drehknopf 5 aufgesetzt, welcher an seiner zur Bedienoberfläche zeigenden Rückseite 13 einen metallischen Vorsprung 14 (Höcker) aufweist, welcher eine nahe Annäherung oder eine Kontaktfläche mit der Bedienoberfläche erzeugt. An seiner Vorderseite weist der Drehknopf 5 zur besseren Bedienerführung eine Erhebung 7 auf.

Der Flächensensor 6 ist ein resistiver Sensor auf der Basis von Indiumzinnoxid (ITO) und weist mehrere eng beabstandete, in einer Matrixform abgeordnete Sensorpunkte (ohne Abbildung) auf. Er ist in der Praxis flächig an der Rückseite 4 der Platte 2 befestigt. Der Satz der durch eine Kontaktierung der Platte 2 aktivierten Sensorpunkte wird auch Cursorfokus 16 genannt. Die Sensorpunkte des Cursorfokus' geben ihre Signale hier über vier elektrische Leitungen 15 an eine, hier nur durch den Pfeil 17 angedeutete, Steuereinheit aus, welcher die aktivierten Sensorpunkte (Cursorfokus) auf eine Korrelation mit vorbestimmten Schaltzonen überprüft ("4-Draht-System"). Die Steuereinheit 17 ist hier als ein Mikrocontroller ausgeführt. Die Schaltzonen sind Sätze von durch eine Programmierung des Mikrocontrollers 17 festgelegten Sensorpunkten, bei deren Aktivierung eine bestimmte Schaltfunktion des Haushaltsgeräts ausgelöst wird. Die Größe, Form und Art der Schaltzonen (als Drehwähler, Taster usw.) und deren Verknüpfung mit einer bestimmten Schaltfunktion sind frei programmierbar und somit flexibel auf das Haushaltsgerät und eine damit verbundene Bedienerführung abstimmbar. Insbesondere können die Art der Schaltzone und die Verknüpfung der Schaltzone mit der Schaltfunktion innerhalb einer Bedienerführung verändert werden, was eine besonders kompakte und bedienerfreundliche Bedienvorrichtung 1 ergibt.

Bei der hier gezeigten Programmierung des Flächensensors 6 liegt der Cursorfokus 16 bei aufgesetztem Drehknopf 5 immer innerhalb der Schaltzone 12 und löst dort die Schaltfunktion aus. Der Mikrocontroller 17 kann dazu eine Änderung der Drehstellung (Position des Cursorfokus' 16) erfassen und eine entsprechende Schaltfunktion auslösen, z. B. ein Höherstellen eines Geräteparameters bei Drehung im Uhrzeigersinn und ein Tieferstellen eines Geräteparameters bei Drehung gegen den Uhrzeigersinn. Die Schaltzone kann alternativ auch ringsektorförmig ausgestaltet sein, so dass der Mikrocontroller 17 eine Änderung der Drehstellung durch einen Übergang des Cursorfokus' 16 von einem Sektor in den nächsten Sektor feststellen kann (ohne Abb.). Jeder Sektor kann dann eine vorbestimmte Funktion aufweisen, z. B. einen vorbestimmten Parameter einstellen, oder beispielsweise auch nur Änderungen zur Parameterverstellung erfassen.

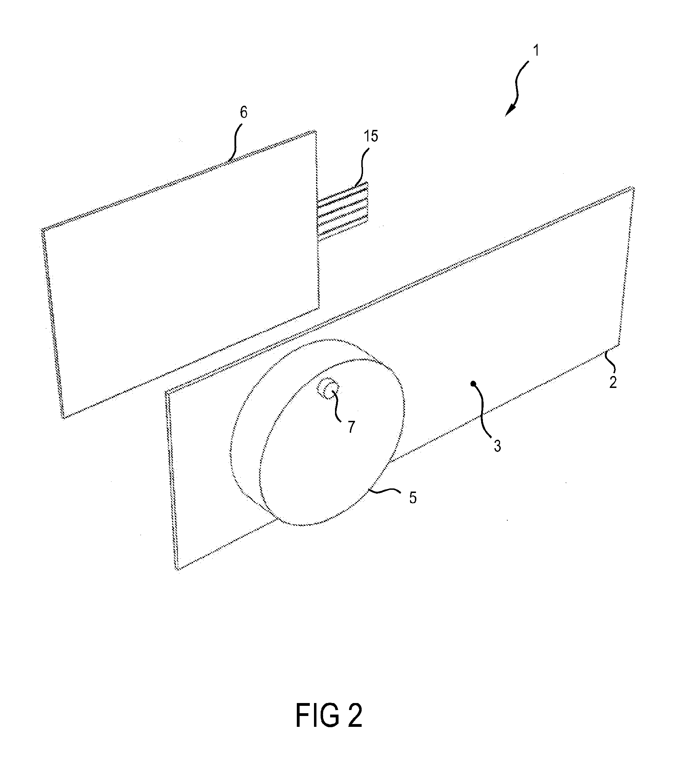

**Fig.2** zeigt, dass bei aufgesetztem Drehknopf 5 der Ring 8 nicht mehr sichtbar ist. Für einen Bediener sieht der Drehknopf 5 wie derjenige eines herkömmlichen Drehschalters aus, was von einigen Bedienern als vertraut und zuverlässig empfunden wird.

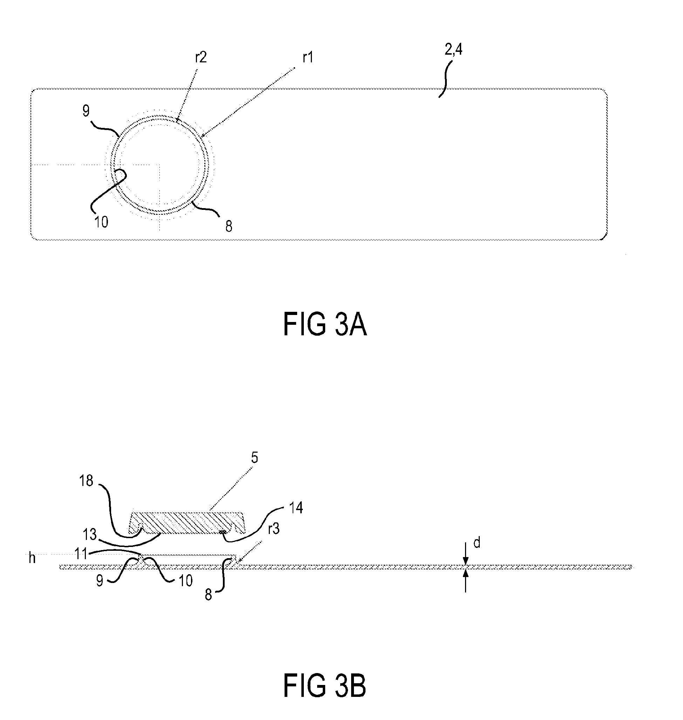

**Fig.3A** zeigt die unbedruckte Bedienoberfläche 4 der Platte 2, während **Fig.3B** die Platte 2 von unten zeigt. Die rechteckige Grundform ist an den Ecken abgerundet. Der Außenradius des Rings beträgt r1 = 49 mm, der Innenradius r2 = 45 mm und die radiale Dicke des Rings in der Ebene folglich 4 mm. Die Dicke d der Platte beträgt 2 mm und die Höhe h des Rings 4 mm. Die Außenfläche 9 und die Innenfläche 10 sind zur Bedienoberfläche hin mit einem Radius r3 abgerundet. An der Rückseite 13 ist in den Drehknopf 5 eine zum Ring 8 passende Aussparung in Form einer ringförmigen Nut 18 eingebracht. Der Drehknopf 5 kann somit durch einfaches Aufstecken auf den Ring 8 so, dass der Ring 8 in die Nut 18 pressend eingreift, aufgesetzt und durch Abziehen wieder entfernt werden.

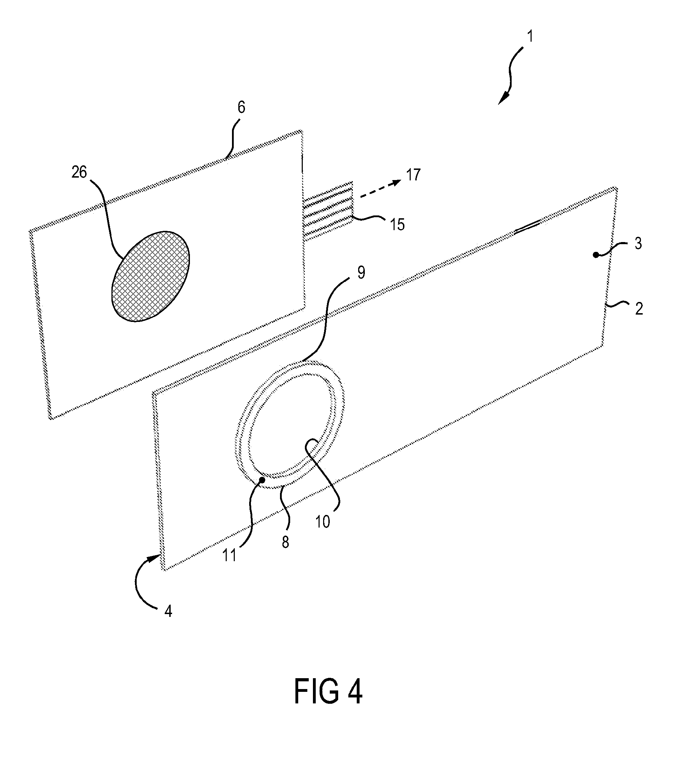

**Fig.4** zeigt die Bedienvorrichtung 1 aus Fig.1 mit einem unterschiedlich programmierten Flächensensor 6, bei dem nun dem Ring 8 eine kreisförmige Schaltzone 26 hinterlegt ist, bei deren Aktivierung eine durch die Programmierung festgelegte Schaltfunktion ausgelöst wird. Der Ring 8 wirkt dabei als sichtbare und haptische äußere Begrenzung der Schaltzone 26. Im Gegensatz zur Schaltzone 12 aus Fig.1 ist die Schaltzone 26 nicht positionssensitiv und wirkt bei deren Aktivierung somit ähnlich zu einem Drucktaster. Die Schaltzone 26 kann in dem gleichen Haushaltsgerät eingesetzt werden wie die Schaltzone 12 aus Fig.1, aber beispielsweise in einem anderen Bedienkontext, wie innerhalb einer anderen Stufe einer Menuführung. In anderen Worten kann mittels des Mikrocontrollers 17 die Schaltzone 12,26 dynamisch zwischen einer Verwendung zur drehwählerartigen Bedienung und einer Verwendung zur tasterartigen Bedienung umprogrammiert werden, was eine besonders flexible und kompakte Bedienerführung zulässt. So mag die Schaltzone 12 zunächst zur drehwählerartigen Parametereinstellung einer Betriebsart des Haushaltsgeräts programmiert sein und danach als tasterartige Schaltzone 26 zum Start der Betriebsart umprogrammiert werden.

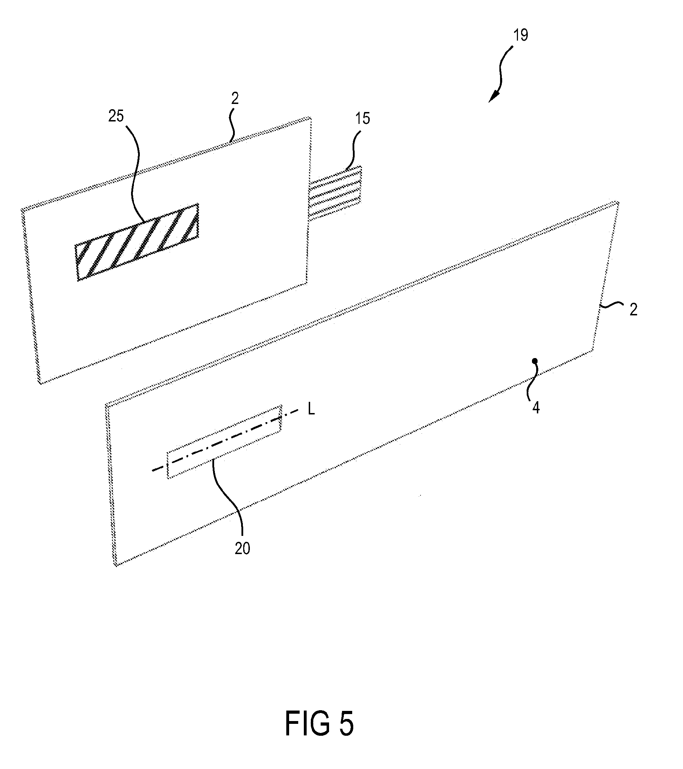

**Fig.5** zeigt eine Bedienvorrichtung 19 gemäß einer zweiten Ausführungsform, bei der nun das Bedienerführungselement in Form einer waagerecht liegenden, linearen Aussparung 20 vorliegt. Die Aussparung 20 weist quer zur Längsrichtung L eine gekrümmte Oberflächenkontur auf, um eine Bedienung mittels eines Fingers zu vereinfachen. Durch die Aussparung kann insbesondere eine Parameterverstellung einfach eingestellt werden, z. B. indem ein Bediener bei einem Gleiten seines Fingers nach rechts (oder links) einen Parameter erhöht und bei einem Gleiten nach links (oder rechts) einen Parameter verringert. Die zugehörige Schaltzone 25 entspricht der Aufsichtsfläche auf die Aussparung 20. Der Cursorfokus auf dem Flächensensor 6 entspricht in etwa der Berührungsfläche des Fingers. Ein solches Bedienerführungselement 20 entspricht somit in seiner Funktion der eines Linearsliders.

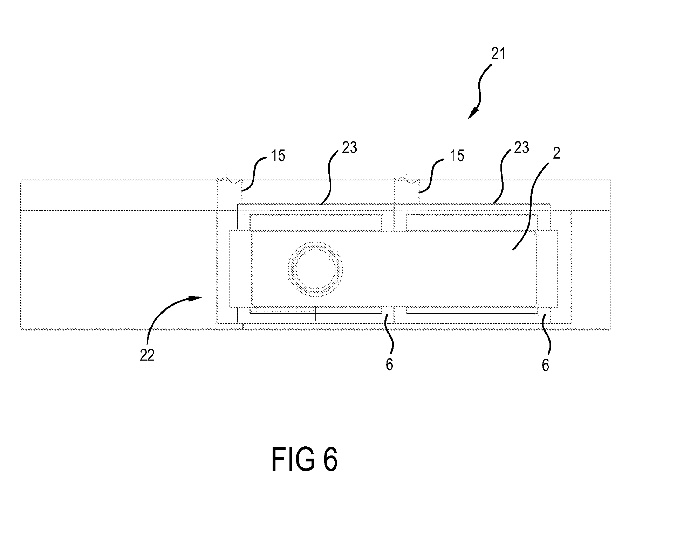

**Fig.6** zeigt in Vorderansicht die Lage von Komponenten einer Bedienblende 21 mit einer Bedienvorrichtung 22 gemäß einer dritten Ausführungsform. Die Bedienvorrichtung 22 weist eine transparente PMMA-Platte 2 entsprechend derjenigen aus Fig.1 auf, die jedoch nicht von einem Flächensensor 6 hinterlegt ist, sondern von zwei ITO-Flächensensoren 6. Zur optischen Ausgestaltung der Bedienvorrichtung 22, z. B. durch einfarbiges oder mehrfarbiges Anzeigen von Texten, Symbolen, Flächen usw., ist hinter den transparenten Flächensensoren 6 jeweils ein frei programmierbarer Monitor 23 beabstandet angebracht. Die auf den Monitoren 23 angezeigten Bilder werden durch die transparenten Flächensensoren 6 hindurch auf die ebenfalls Platte 2 projiziert und sind dort von einem Bediener ablesbar. Durch die freie Programmierbarkeit der Monitore, z. B. in Form von Flüssigkristallanzeigen oder LED-Displays, kann die optische Kennzeichnung besonders einfach geändert werden, z. B. zur Anpassung an verschiedene Landessprachen, an verschiedene Arten von Hausgeräten und / oder insbesondere zur dynamischen Anpassung einer bestimmten Beschriftung an eine Schaltzone.

Die beispielhaft gezeigten Bedienvorrichtungen weisen insbesondere den Vorteil auf, dass sie besonders einfach herstellbar sind; so benötigen sie minimal zwei Elemente, nämlich die Platte und den Flächensensor, wobei die Platte einfach einstückig herstellbar ist. Zudem ist die Bedienvorrichtung flexibel konfigurierbar herzustellen durch Austausch der Platte und Umprogrammierung des Flächensensors; dadurch können auf einfache Weise verschieden geformte Schaltelemente bereitgestellt werden (Drucktaster, Drehschalter, Linearslider usw.). Auch ist durch eine dynamische Umprogrammierung eine besonders kompakte und bedienerfreundliche Bedienvorrichtung erreichbar. Insbesondere auch mittels des Vorsehens aufsetzbarer Bedienelemente wird eine besonders hohe Bedienerfreundlichkeit aufgrund der flexiblen Konfigurationsmöglichkeit erreicht.

Selbstverständlich ist die vorliegende Erfindung nicht auf die gezeigten Ausführungsbeispiele beschränkt.

So kann die Platte auch aus Glas, einschließlich Glaskeramik, oder sogar Metall bestehen. Es können auch andere Bedienerführungselemente in die Platte eingebracht sein, wie kreisförmige Vertiefungen. Es können auch andere Schalterarten vorgesehen sein, wie eine drucktasterartige Schaltung, z. B. durch Drücken einer kreisförmigen Vertiefung. Dabei wie eine Schaltfunktion vorzugsweise dann ausgelöst, wenn ein Cursorfokus zumindest einen gemeinsamen Sensorpunkt mit der zugehörigen Schaltzone aufweist. Es sind zudem Mehrpunktschaltungen möglich, bei denen gleichzeitig mehrere Cursorfoki ausgewertet werden. Selbstverständlich kann eine Platte mehrere Bedienerführungselemente aufweisen. Die Bedienvorrichtung kann auch Schaltzonen aufweisen, denen keine Bedienerführungselemente zugewiesen sind. So mögen Drehbetätigungen (mittels Ring, Drehknopf usw.) ein ringförmiges Bedienerführungselement aufweisen, aber Schaltzonen zur tastenden Aktivierung weder eine Erhebung noch eine Vertiefung aufweisen, sondern beispielsweise einzig durch eine optische Kennzeichnung, z. B. eine Bedruckung oder eine Bildprojektion, gekennzeichnet sein. Auch mag der Flächensensor als 5-Draht- oder 8-Draht-System ausgeführt sein.

Anstelle des Flächensensors kann auch ein Liniensensor verwendet werden. So kann z.B. bezüglich Fig.4 der Liniensensor ein ringförmiger Sensor mit mehreren ringsektorförmigen Schaltzonen sein, wobei der Liniensensor hinter dem Ring 8 angeordnet ist und eine zur einfachen und fehlerfreien Bedienung ausreichende Breite aufweist. Dazu kann die Breite z.B. eine innerhalb des Rings 8 etwa fingerbreite Ausdehnung aufweisen.

Alternativ kann anstelle des Flächensensors auch eine Gruppe ringförmig angeordneter Einzelsensoren mit jeweils einer einzigen Schaltzone verwendet werden.

### Bezugszeichenliste

- 1: Bedienvorrichtung
- 2: Platte
- 3: Bedienoberfläche
- 4: Rückseite
- 5: Drehknopf
- 6: Flächensensor
- 7: Erhebung
- 8: Ring
- 9: Außenfläche
- 10: Innenfläche
- 11: oberer Rand
- 12: Schaltzone
- 13: Rückseite des Drehknopfs
- 14: Vorsprung
- 15: elektrische Leitung
- 16: Cursorfokus
- 17: Steuereinheit
- 18: Nut
- 19: Bedienvorrichtung
- 20: Aussparung
- 21: Bedienblende
- 22: Bedienvorrichtung
- 23: Monitor
- 25: Schaltzone
- 26: Schaltzone
- r: Radius

## Patentansprüche

1. Bedienvorrichtung (1;19;22) für ein Hausgerät, aufweisend eine Platte (2), deren Vorderseite als Bedienoberfläche (3) vorgesehen ist und an deren Rückseite (4) mindestens ein berührungsempfindlicher, insbesondere resistiver, Sensor (6) angeordnet ist, wobei die Vorderseite (3) mindestens ein dreidimensional strukturiertes Bedienerführungselement (8;20) aufweist.

2. Bedienvorrichtung (1; 19; 22) nach Anspruch 1, bei welcher der Sensor (6) einen Flächensensor umfasst.

3. Bedienvorrichtung (1; 19; 22) nach einem der vorhergehenden Ansprüche, bei welcher der Sensor einen Liniensensor umfasst.

4. Bedienvorrichtung (1; 19; 22) nach einem der vorhergehenden Ansprüche, bei welcher der Sensor eine Gruppe von Einzelsensoren umfasst.

5. Bedienvorrichtung (19) nach einem der vorhergehenden Ansprüche, bei der das Bedienerführungselement eine Vertiefung (20) aufweist.

6. Bedienvorrichtung (1;22) nach einem der vorhergehenden Ansprüche, bei der das Bedienerführungselement eine Erhebung (8) aufweist.

7. Bedienvorrichtung (1;19;22) nach einem der vorhergehenden Ansprüche, bei der das mindestens eine Bedienerführungselement (8;20) kreisförmig, länglich und / oder ringförmig ist.

8. Bedienvorrichtung (1;22) nach den Ansprüchen 6 und 7, bei der die Erhebung (8) ringförmig ist und zumindest zur randseitigen Bedienerführung vorgesehen ist.

9. Bedienvorrichtung (1;22) nach einem der vorhergehenden Ansprüche, bei der das Bedienerführungselement (8) zum Aufsetzen eines Bedienelements (5) zur Betätigung des Sensors (6) eingerichtet ist.

10. Bedienvorrichtung (1) nach einem der vorhergehenden Ansprüche, aufweisend mindestens ein wahlweise auf ein Bedienerführungselement (8) aufsetzbares und abnehmbares Bedienelement (5).

11. Bedienvorrichtung (1) nach Anspruch 10, bei der das aufgesetzte Bedienelement (5) mechanisch gehalten wird.

12. Bedienvorrichtung (1;22) nach Anspruch 10 oder 11, bei der das mindestens eine Bedienelement einen Drehknopf (5) und / oder einen Druckknopf aufweist.

13. Bedienvorrichtung (1;19;22) nach einem der vorhergehenden Ansprüche, bei welcher der Sensor (6) frei programmierbar ist.

14. Hausgerät, aufweisend mindestens eine Bedienvorrichtung nach einem der vorhergehenden Ansprüche.
